# EUROPÄISCHE PATENTSCHRIFT

(11) **EP 1 163 724 B1**
(45) Veröffentlichungstag und Bekanntmachung des Hinweises auf die Patenterteilung: **04.09.2002**
(21) Anmeldenummer: 00916775.0
(22) Anmeldetag: 01.03.2000
(51) Int. Cl.: H03K 19/003

(54) **KOMPENSATIONSSCHALTUNG FÜR TREIBERSCHALTUNGEN**
COMPENSATION CIRCUIT FOR DRIVER CIRCUITS
CIRCUIT DE COMPENSATION POUR CIRCUITS D'ATTAQUE

(30) Priorität: 09.03.1999 DE 19910352
(43) Veröffentlichungstag der Anmeldung: 19.12.2001
(73) Patentinhaber: Infineon Technologies AG, 81669 München (DE)
(72) Erfinder: FRIEBE, Dirk, D-81671 München (DE); SANDERS, Anthony, D-80636 München (DE)
(74) Vertreter: Barth, Stephan Manuel, Dr.
(86) Internationale Anmeldenummer: DE0000592
(87) Internationale Veröffentlichungsnummer: WO00054408

(56) Entgegenhaltungen:
- EP-A- 0 714 167
- EP-A- 0 765 037
- US-A- 5 111 081
- US-A- 5 539 341
- US-A- 5 703 517

## Beschreibung

Die vorliegende Erfindung betrifft eine Kompensationsschaltung für Treiberschaltungen gemäß dem Oberbegriff des Anspruches 1, wie aus der EP 0 480 517 A2 bekannt.

Die EP 0 765 037 A2 offenbart eine Ausgangstreiberschaltung mit zwei Ausgangsstransistoren, wobei eine Kompensationsschaltung zur Temperaturkompensation mit adaptiver Steuerung der Flankensteilheit vorgesehen ist.

Die Signale von Eingabe-/Ausgabepadzellen (I/O-Padzelle) einer integrierten Schaltung müssen je nach Spezifikation bzw. je nach gewünschter Anforderung eine definierte, minimale Flankensteilheit der Signale über die I/O-Padzellen aufweisen. Infolge von Temperatur-, Spannungs- und Prozeßschwankungen kann es jedoch zu mehr oder weniger starken Abweichungen der Flankensteilheit kommen. Aufgrund dessen müssen Treiberschaltungen für I/O-Padzell so ausgelegt sein, daß auch im sogenannten "Worst Case", d.h. bei sehr hoher Temperatur, niedriger Versorgungsspannung und "langsamen" Prozeßparametern, eine minimale Flankensteilheit garantiert werden kann.

Bislang werden hierzu Treiberschaltungen verwendet, die alle obengenannten Anforderungen gleichzeitig erfüllen. Die daraus resultierenden Treiberschaltungen sind jedoch für die meisten Temperatur-, Spannungs- und Prozeßwerte überdimensioniert, wodurch ein erhöhter, sogenannter "Ground Supply Bounce" verursacht wird, der die Funktionsfähigkeit der gesamten integrierten Schaltung negativ beeinflussen und im schlimmsten Fall zu Fehlfunktionen führen kann.

Der vorliegenden Erfindung liegt daher die Aufgabe zugrunde, eine Kompensationsschaltung für Treiberschaltungen anzugeben, die auch bei ungünstigen Bedingungen eine definierte, minimale Flankensteilheit eines Signals bei I/O-Padzellen sicherstellt.
Erfindungsgemäß wird diese Aufgabe durch eine Kompensationsschaltung für Treiberschaltungen mit den Merkmalen des Patentanspruchs 1 gelöst.

Vorteilhafte Ausgestaltungen und Weiterbildungen der Erfindung sind Gegenstand der abhängigen Ansprüche.

Erfindungsgemäß ist hierfür eine digital gesteuerte Kompensationsschaltung bzw. Kompensationseinheit (Digitally Controlled Compensation Unit; DCCU) vorgesehen, die der Treiberschaltung vorgeschaltet ist. Diese erfindungsgemäße Kompensationseinheit besteht im wesentlichen aus vier Schaltungsteilen: einer Stromreferenzquelle, einer Stromvergleichsquelle, einer Komparatorstufe und einer Logikstufe. Die Kompensationseinheit dient der Kompensation von Temperatur-, Spannungsund Prozeßschwankungen in den Treiberschaltung für die I/O-Padzellen. Auf diese Weise wird die Flankensteilheit der Signale über diese I/O-Padzellen kontrolliert und über die obengenannten Schwankungen annähernd konstant gehalten. Des weiteren kann dadurch ein erheblich reduzierter "Ground Supply Bounce" erzielt werden.

Die Erfindung wird nachfolgend anhand der in den Figuren der Zeichnung angegebenen Ausführungsbeispielen näher erläutert. Es zeigt dabei :
Figur 1 ein prinzipielles Blockschaltbild für die erfindungsgemäße Kompensationseinheit;
Figur 2 Detailschaltbilder für Teile der Kompensationseinheit.

In den Figuren der Zeichnung sind, sofern dies nicht anders angegeben ist, gleiche bzw. funktionsgleiche Elemente mit gleichen Bezugszeichen versehen.

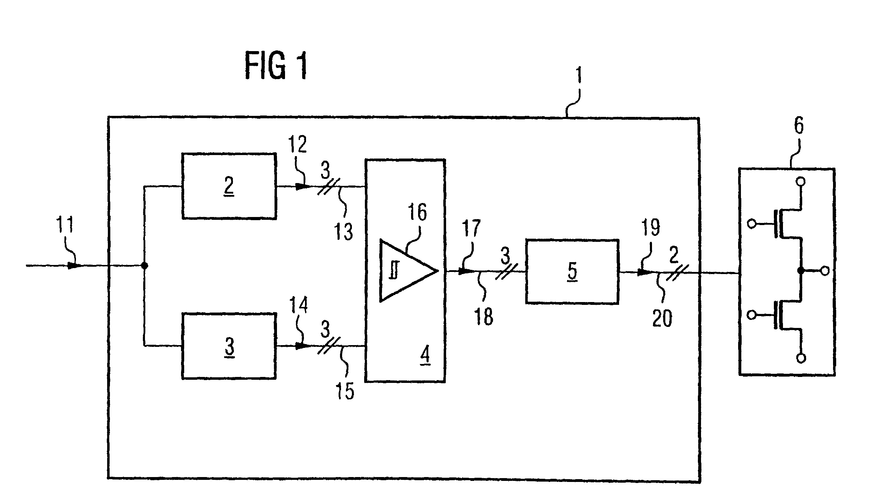

Figur 1 zeigt ein Blockschaltbild der erfindungsgemäßen Kompensationseinheit, die hier mit 1 bezeichnet ist. Die erfindungsgemäße Kompensationseinheit 1 besteht im wesentlichen aus vier Schaltungsteilen: einer Stromreferenzquelle 2, einer Stromvergleichsquelle 3, einer Komparatorstufe 4 und einer Logikstufe 5. Die Stromreferenzquelle 2 und die Stromvergleichsquelle 3 sind ausgangsseitig mit den Eingängen der Komparatorstufe 4 verbunden. Ausgangsseitig ist der Komparatorstufe 4 die Logikstufe 5 nachgeschaltet. Der Logikstufe 5 und damit der Kompensationsschaltung 1 ist ausgangsseitig mindestens eine Treiberschaltungen 6 nachgeschaltet.

Die Stromreferenzquelle 2 generiert aus einem Eingangssignal 11 einen Referenzstrom, der mit ansteigender Temperatur bzw. Versorgungsspannung zunimmt und mit fallender Temperatur bzw. Versorgungsspannung abnimmt. Dieser Referenzstrom wird über einen Stromspiegel in drei identische Referenzströme 12 aufgeteilt, die über drei Stromzweige 13 aus der Stromreferenzquelle 2 herausgeführt werden.

Die Stromvergleichsquelle 3 weist ein zu der Stromreferenzquelle 2 umgekehrt proportionales Temperaturverhalten auf. Die Stromvergleichsquelle 3 generiert also aus dem Eingangssignal 11 einen Vergleichsstrom, der mit ansteigender Temperatur abfällt und der mit fallender Temperatur zunimmt. Über einen Stromspiegel werden aus diesem Vergleichsstrom drei identische Vergleichsströme 14 generiert, die aus der Stromvergleichsquelle über drei Stromzweige 15 herausgeführt werden.

Die Referenzströme 12 und die Vergleichsströme 13 werden der nachgeschalteten Komparatorstufe 4 zugeführt. Die Komparatorstufe besteht im vorliegenden Ausführungsbesipiel aus drei Komparatoren 16, denen jeweils einer der drei Stromzweige 13 der Stromreferenzquelle 2 und jeweils einer der drei Stromzweige 15 der Stromvergleichsquelle 3 zugeführt werden. Abhängig davon, welcher der Ströme 12, 14 vom Betrag her größer ist, erzeugt jeder der drei Komparatoren 16 an dessen Ausgang ein digitales Ausgangssignal 17 mit einem entsprechenden HIGH-Pegel oder LOW-Pegel. Diese digitalen Ausgangssignale 17 werden aus der Komparatorstufe 4 über drei Stromzweige 18 herausgeführt.

Die Komparatoren 16 der Komparatorstufe 4 können vorteilhafterweise als bekannte Präzisions-Schmitt-Trigger mit anpaßbarer Schalthysterese ausgebildet sein.

Die drei digitalen Ausgangssignale 17 werden der Logikstufe 5 zugeführt. Die Logikstufe 5 enthält eine Vielzahl von logischen Grundgatterschaltungen, die die drei digitalen Ausgangssignale 17 in zwei digitale Kompensationssignale 19 wandeln. Es wird somit eine Verknüpfung eines 3-Bit Ausgangssignals 17 in ein 2-Bit Kompensationssignal 19 durchgeführt. Das 2-Bit Kompensationssignal 19 der Logikstufe 5 wird ausgangsseitig über zwei Signalpfade 20 den Steueranschlüssen einer oder mehrerer nachgeschalteter Treiberschaltungen 6 zugeführt.

Die digitalen Ausgangssignale 19 der Kompensationseinheit 1 können, je nach Abhängigkeit von Temperatur, Spannung und Prozeßparametern, vier verschiedene Zustände annehmen, die die Treiberstärke der nachgeschalteten Treiberschaltung der anzusteuernden I/O-Padzellen schalten. Die der Kompensationseinheit 1 nachgeschaltete Treiberschaltung kann also abhängig von diesen Parametern optimal angesteuert werden. Die oben genannte Aufzählung der Parameter, d.h. Temperatur, Spannung und Prozeßparametern, soll hier nicht als abschließend angesehen werden, wenngleich diese auch als die relevantesten angesehen werden. Zum Beispiel wäre es auch denkbar, andere Parameter wie Druck, Feuchtigkeit, etc. ebenfalls für die Erzeugung eines Kompensationssignals zu berücksichtigen.

Die erfindungsgemäße Kompensationseinheit 1 basiert auf einem Stromvergleich, wobei die beiden Stromquellen, d.h. die Stromreferenzquelle 2 und Stromvergleichsquelle 3, ein zueinander umgekehrt proportionales Temperaturverhalten aufweisen. Erfindungswesentlich ist dabei, daß die Kompensationseinheit 1 an der gleichen Versorgungsspannung wie die Eingabe/Ausgabepadzellen angeschlossen sind. Dadurch wird gewährleistet, daß die Kompensationseinheit 1 dieselbe Spannungsabhängigkeit wie die I/O-Padzellen erreicht. Das Temperaturverhalten einer integrierten Schaltung ist an jedem Port annähernd gleich, wodurch sich für die I/O-Padzellen und die Kompensationseinheit 1 nahezu die gleiche Temperaturcharakteristik ergibt.

In einer Weiterbildung kann die die Kompensationseinheit 1 auch über einen weiteren Eingangsanschluß oder einen Enableanschluß (in Figur 1 nicht dargestellt) aktiviert bzw. deaktiviert werden.

Das Ausführungsbeispiel gemäß Figur 1 zeigt eine bevorzugte Realisierung der erfindungsgemäßen Kompensationseinheit 1. Selbstverständlich wäre diese aber auch auf vielseitige Art und Weise abwandelbar.

Beispielsweise wäre es auch denkbar ein 1-Bit oder 3- oder Mehrbit-Kompensationssignal 19 am Ausgang der Kompensationseinheit 1 bereitzustellen. Ferner müssen die Vergleichs- bzw. Referenzströme 12, 14 nicht notwendigerweise aus drei Strömen bestehen, sondern es wäre auch denkbar mehr oder weniger viele Vergleichs-/Referenzströme 12, 14 bereitzustellen. Wesentlich ist hierbei lediglich, daß die Anzahl der Vergleichsströme 12 und der Referenzströme 14 gleich ist. Allerdings wären die gerade beschriebenen Abwandlungen ggfs. schaltungstechnisch schwieriger und aufwendiger zu realisieren.

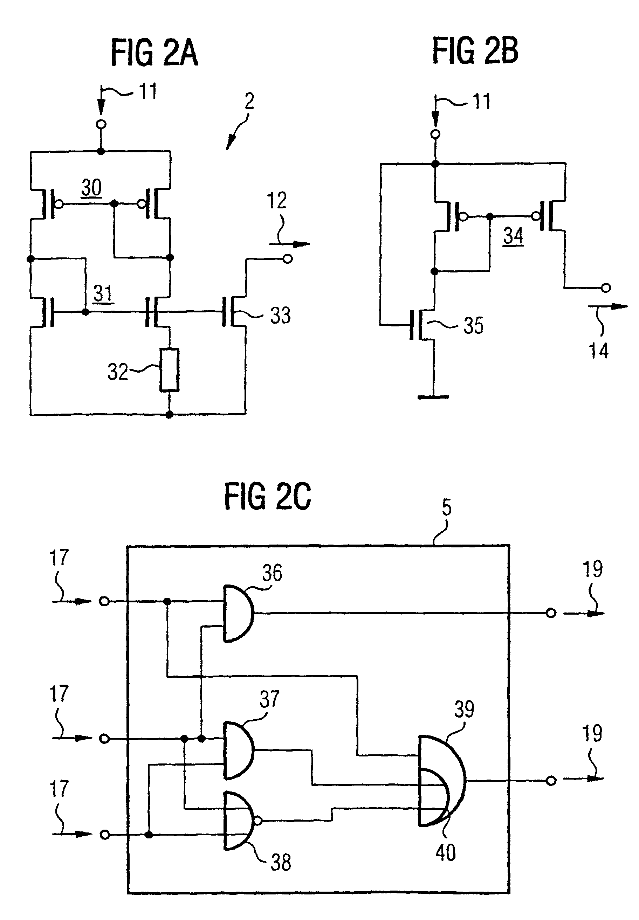

In Figur 2 sind einige Detailschaltbilder für einige Schaltungsteile der Kompensationseinheit 1 in typischen Ausführungsformen kurz beschrieben.

Figur 2a zeigt den schaltungstechnischen Aufbau einer Stromreferenzquelle 2. Die Stromreferenzquelle 2 besteht typischerweise aus zwei Stromspiegeln 30, 31, die jeweils über ihre Laststrecken in Reihe und zueinander komplementär angeordnet sind. Die beiden Stromspiegel 30,31 weisen jeweils MOS-Transistoren des entgegengesetzten Typs auf. Zusätzlich ist in eine der Laststrecken der in Reihe angeordneten Stromspiegel 30, 31 ein resistives Element 32, beispielsweise ein Widerstand, angeordnet. Ausgangsseitig ist außerdem ein MOS-Ausgangstransistor 33 vorgesehen, dessen Laststrecke mit den Laststrecken der Stromspiegel 30, 31 in Reihe geschaltet ist und dessen Steueranschluß mit einem Steueranschluß eines Stromspiegels 31 verbunden ist. Am Ausgang der Stromreferenzquelle 2 ist dann der Referenzstrom 12 abgreifbar, der dann, wie bereits erwähnt, mittels Stromspiegel (in Figur 2a nicht dargestellt) in drei gleich große Referenzströme 12 aufgeteilt wird.

Die Stromreferenzquelle 2 erzeugt also aus dem Eingangssignal 11 einen Referenzstrom 12, der mit ansteigender Temperatur zunimmt. Es ist deshalb notwendig, daß die Gatepotentiale der Transistoren 30, 31, 33 der Stromreferenzquelle 2 immer ein definiertes Potential ungleich 0 aufweisen, so daß eine Temperaturschwankung auch definiert erkannt werden kann.

Die Stromvergleichsquelle 3 besteht nach Figur 2b typischerweise aus einem einfachen Stromspiegel 34 und einem einzelnen Transistor 35, der in Reihe zu dem Laststromeingang des Stromspiegels 34 angeordnet ist. Der Stromspiegel 34 und der Transistor 35 weisen typischerweise MOS-Transistoren des entgegengesetzten Typs auf. Diese MOS-Transistoren weisen ein ähnliches Temperaturverhalten wie die Transistoren der Vortreiberstufe, die die Geschwindigkeit der Treiberschaltung 6 steuert, auf.

Die Logikstufe 5 in Figur 2c moduliert lediglich die digitalen 3-Bit-Ausgangssignale 17 der Komparatorstufe 4 in ein 2-Bit-Kompensationssignal 19, welches auch das Ausgangssignal der Kompensationseinheit 1 darstellt. Dies 3-Bit/2-Bit Signalmodulation ist auf einfache Weise mit Hilfe von verschiedenen logischen Grundgatterschaltungen 36..40 möglich. Die Signalmodulation erfolgt anhand dreier UND-Gatter 36, 37, 39, eines ODER-Gatters 38 und eines NOR-Gatters 40.

### Bezugszeichenliste

- 1: Kompensationsschaltung, Kompensationseinheit
- 2: Stromreferenzquelle
- 3: Stromvergleichsquelle
- 4: Komparatorstufe, Vergleichseinheit
- 5: Logikstufe
- 6: Treiberschaltung

- 11: Eingangssignal
- 12: Referenzströme
- 13, 15, 18, 20: Stromzweige
- 14: Vergleichsströme
- 16: Komparatoren
- 17: (digitales) Ausgangssignal
- 19: (digitales) Kompensationssignal

- 30, 31, 34: Stromspiegel
- 32: resistives Element, Widerstand
- 33: Lasttransistor, Ausgangstransistor
- 35: Transistor
- 36, 37, 39: UND-Gatterschaltungen
- 38: ODER-Gatterschaltung
- 40: NOR-Gatterschaltung

## Patentansprüche

1. Kompensationsschaltung (1 die einer Treiberschaltung (6) vorschaltbar ist,
mit einer Signalreferenzquelle (2),
die aus einem Eingangssignal (11) mindestens ein Referenzsignal (12) erzeugt, wobei das Referenzsignal eine Parameterabhängigkeit aufweist,
mit einer Signalvergleichsquelle (3),
die aus dem Eingangssignal (11) mindestens ein Vergleichssignal (14) erzeugt,
wobei das Vergleichssignal (14) eine inverse Parameterabhängigkeit zum Referenzsignal (12) aufweist,
mit einer Vergleichseinheit (4),
der das Referenzsignal (12) und das Vergleichssignal (14) zuführbar sind und die aus einem Vergleich des Referenzsignals (12) und des Vergleichssignals (14) mindestens ein digitales Ausgangssignal (17) erzeugt,
**dadurch gekennzeichnet,**
**daß** die Signalreferenzquelle (2) einen Referenzstrom als Referenzsignal (12) erzeugt und die Signalvergleichsquelle (3) einen Vergleichsstrom als Vergleichssignal (14) erzeugt, daß die Signalreferenzquelle (2) und die Signalvergleichsquelle (3) jeweils eine Mehrzahl gleich großer Referenzsignale (12) bzw. Vergleichssignale (14) erzeugen, die jeweils in eine entsprechende Anzahl von Komparatoren (16) der Vergleichseinheit (4) zuführbar sind, und daß die Vergleichseinheit (4) daraus eine der Anzahl der Komparatoren (16) entsprechende Anzahl digitaler Ausgangssignale (17) bereitstellt.

2. Kompensationsschaltung nach Anspruch 1,
**dadurch gekennzeichnet,**
**daß** eine Logikschaltung (5) vorgesehen ist, der die digitalen Ausgangssignale (17) der Vergleichseinheit (4) zuführbar sind und die mindestens ein, aus dem Ausgangssignal (17) erzeugtes, digitales Kompensationssignal (19) bereitstellt.

3. Kompensationsschaltung nach Anspruch 2,
**dadurch gekennzeichnet,**
**daß** die Logikschaltung (5) ein digitales, 2-Bit breites Kompensationssignal (19) bereitstellt.

4. Kompensationsschaltung nach einem der vorstehenden Ansprüche,
**dadurch gekennzeichnet,**
**daß** die Vergleichseinheit (4) ein 3-Bit breites Ausgangssignal (17) bereitstellt.

5. Kompensationsschaltung nach einem der vorstehenden Ansprüche,
**dadurch gekennzeichnet,**
**daß** der Parameter die Temperatur und/oder die Versorgungsspannung und/oder mindestens ein Prozeßparameter ist.

6. Kompensationsschaltung nach einem der vorstehenden Ansprüche,
**dadurch gekennzeichnet,**
**daß** die Vergleichseinheit (4) als Präzisions-Schmitt-Trigger mit einstellbarer Schalthysterese ausgebildet ist.

7. Kompensationsschaltung nach einem der vorstehenden Ansprüche,
**dadurch gekennzeichnet,**
**daß** die Signalreferenzquelle (2) Transistoren (30, 31, 33) aufweist, deren Steueranschlüsse jeweils immer ein definiertes Potential ungleich null aufweisen.

8. Ausgangstreiberschaltung (6),
mit zwei Ausgangstransistoren, deren Laststrecken in Reihe zwischen einem ersten und einem zweiten Versorgungspotential angeordnet sind,
die einen Ausgang aufweist, an dem ein Ausgangssignal abgreifbar ist und
die einen Eingang aufweist, der mit einer Kompensationsschaltung (1) nach einem der vorstehenden Ansprüche gekoppelt ist, wobei der Ausgangstreiberschaltung (6) über die Kompensationsschaltung (1) ein kompensiertes Signal (19) zuführbar ist.

## Claims

1. Compensation circuit (1) which can be connected upstream of a driver circuit (6),
having a signal reference source (2), which generates from an input signal (11) at least one reference signal (12), the reference signal having a parameter-dependence,
having a signal-comparison source (3) which generates from the input signal (11) at least one comparison signal (14), the comparison signal (14) having an inverse parameter-dependence to that of the reference signal (12),
having a comparison unit (4) to which the reference signal (12) and the comparison signal (14) can be fed and which generates at least one digital output signal (17) from a comparison of the reference signal (12) and of the comparison signal (14), **characterized in that** the signal reference source (2) generates a reference current as a reference signal (12), and the signal-comparison source (3) generates a comparison current as a comparison signal (14), **in that** the signal reference source (2) and the signal-comparison source (3) each generate a plurality of equally large reference signals (12) or comparison signals (14) which can each be fed into a corresponding number of comparators (16) of the comparison unit (4), and **in that** the comparison unit (4) makes available therefrom a number of digital output signals (17) corresponding to the number of comparators (16).

2. Compensation circuit according to Claim 1, **characterized in that** a logic circuit (5) is provided to which the digital output signals (17) of the comparison unit (4) can be fed and which makes available at least one digital compensation signal (19) which is generated from the output signal (17).

3. Compensation circuit according to Claim 2, **characterized in that** the logic circuit (5) makes available a digital, two-bit-wide compensation signal (19) at the output end.

4. Compensation circuit according to one of the preceding claims, **characterized in that** the compensation unit (4) makes available a three-bit-wide output signal (17).

5. Compensation circuit according to one of the preceding claims, **characterized in that** the parameter is the temperature and/or the supply voltage and/or at least one process parameter.

6. Compensation circuit according to one of the preceding claims, **characterized in that** the comparison unit (4) is embodied as a precision Schmitt trigger with adjustable switching hysteresis.

7. Compensation circuit according to one of the preceding claims, **characterized in that** the signal reference source (2) has transistors (30, 31, 33) whose control terminals each always have a defined potential which is unequal to zero.

8. Output driver circuit (6),
having two output transistors whose load paths are arranged in series between a first supply potential and a second supply potential,
which has an output at which an output signal can be tapped, and
which has an input which is coupled to a compensation circuit (1) according to one of the preceding claims, it being possible to feed a compensated signal (19) to the output driver circuit (6) via the compensation circuit (1).

## Revendications

1. Circuit de compensation (1), qui peut être branché en amont d'un circuit d'attaque (6), comportant
une source (2) de référence de signaux, qui produit au moins un signal de référence (12) à partir d'un signal d'entrée (11), le signal de référence présentant une dépendance vis-à-vis d'un paramètre,
une source (3) de comparaison de signaux, qui produit au moins un signal de comparaison (14) à partir du signal d'entrée (11), le signal de comparaison (14) présentant une dépendance vis-à-vis d'un paramètre, qui est inverse de celle du signal de référence (12),
une unité de comparaison (4), à laquelle le signal de référence (12) et le signal de comparaison (14) peuvent être envoyés et qui produit au moins un signal de sortie numérique (17) à partir d'une comparaison du signal de référence (12) et du signal de comparaison (14),
**caractérisé en ce que** la source (2) de référence de signaux produit un courant de référence en tant que signal de référence (12) et la source (3) de comparaison de signaux produit un courant de comparaison en tant que signal de comparaison (14), que la source (2) de référence de signaux et la source (3) de comparaison de signaux produisent respectivement une multiplicité de signaux de référence (12) et de signaux de comparaison (14) de même amplitude, qui peuvent être envoyés respectivement à un nombre correspondant de comparateurs (16) de l'unité de comparaison (4), et que l'unité de comparaison (4) établit, à partir de là, un nombre de signaux de sortie numériques (17), qui correspond au nombre des comparateurs (16).

2. Circuit de compensation selon la revendication 1, **caractérisé en ce qu'**il est prévu un circuit logique (5), auquel les signaux de sortie numériques (17) de l'unité de comparaison (4) peuvent être envoyés et qui établit au moins un signal de compensation numérique (19) produit à partir du signal de sortie (17).

3. Circuit de compensation selon la revendication 2, **caractérisé en ce que** le circuit logique (5) prépare un signal de compensation numérique (19) d'une largeur de 2 bits.

4. Circuit de compensation selon l'une des revendications précédentes, **caractérisé en ce que** l'unité de comparaison (4) prépare un signal de sortie (17) d'une largeur de 3 bits.

5. Circuit de compensation selon l'une des revendications précédentes, **caractérisé en ce que** le paramètre est la température et/ou la tension d'alimentation et/ou au moins un paramètre de traitement.

6. Circuit de compensation selon l'une des revendications précédentes, **caractérisé en ce que** l'unité de comparaison (4) est agencée sous la forme d'un déclencheur de Schmitt de précision présentant une hystérésis réglable de commutation.

7. Circuit de compensation selon l'une des revendications précédentes, **caractérisé en ce que** la source (2) de signaux de référence comporte des transistors (30, 31, 33) dont les bornes de commande possèdent chacune en permanence un potentiel défini différent de zéro.

8. Circuit d'attaque de sortie (6),
comprenant deux transistors de sortie, dont les sections de charge sont branchées en série entre des premier et second potentiels d'alimentation,
qui possède une sortie, sur laquelle un signal de sortie peut être prélevé, et
qui possède une entrée, qui est couplée à un circuit de compensation (1) selon l'une des revendications précédentes, un signal compensé (19) pouvant être envoyé au circuit d'attaque de sortie (6) par l'intermédiaire du circuit de compensation (1).
